# EUROPEAN PATENT APPLICATION

(11) **EP 4 760 995 A1**
(43) Date of publication of application: **17.06.2026**
(21) Application number: 25222149.4
(22) Date of filing: 10.12.2025
(51) Int. Cl.: H01R 12/58, H01R 12/70, H01R 12/71, H01R 13/6471, H01R 13/6587, H01R 13/642

(54) **ELECTRICAL CONNECTOR WITH ALIGNMENT AND RETENTION PINS**

(30) Priority: 12.12.2024 US 202418978100
(71) Applicant: TE Connectivity Solutions GmbH, 8200 Schaffhausen (CH)
(72) Inventor: Gingrich III, Charles Raymond, Middletown, 17057 (US); Miller, Keith Edwin, Middletown, 17057 (US); Champion, Bruce Allen, Middletown, 17057 (US); Rosenau, Joshua Allen, Middletown, 17057 (US); Walton, Scott Eric, Middletown, 17057 (US)
(74) Representative: Johnstone, Edward Ian

(57) **Abstract**

An electrical connector assembly (10) having a housing (12), signal contacts (14) and ground contacts (16). The housing (12) has a mounting side (22) configured to face a circuit board (24). The signal contacts (16) are provided in the housing (12) and have signal contact circuit board mounting sections (34) with signal contact compliant portions (36). The ground contacts (16) are provided in the housing (12) and have ground contact circuit board mounting sections (44) with ground contact compliant portions (46). One or more of the signal contact compliant portions (36) or the ground contact compliant portions (46) have a larger width than the remainder of the signal contact compliant portions (36) and the ground contact compliant portions (46). The one or more of the signal contact compliant portions (36) or the ground contact compliant portions (46) are configured to cooperate with one or more enlarged vias (60, 62) of the circuit board (24) to align the connector assembly (10) with the circuit board (24).

## Description

The invention relates to alignment and retention pins. In particular the invention relates to press fit connectors that are mounted to circuit boards in which one or more retention pins of the press fit connectors facilitates the alignment of the press fit connector on the circuit board.

Backplane systems, such as network systems, servers, data centers, and the like, include a backplane circuit board having electrical connectors mounted thereto. The electrical connectors may include dense arrays of signal contacts and ground contacts. The signal and ground contacts have respective contact tails arranged along a mounting side of the electrical connector. The contact tails are configured to be inserted into vias, such as plated thru-holes (PTHs), of the circuit board. The contact tails can be relatively thin and, therefore, susceptible to damage. For instance, if the contact tails and the vias are misaligned when the electrical connector is mounted to the circuit board, the contact tails may press against an exterior surface of the circuit board. In such instances, moving the electrical connector along the circuit board to correctly position the contact tails may bend or otherwise damage the contact tails.

In order to proper align the contact tails with the plated thru-holes, alignment features, such as guideposts or alignment pins, are often used to pre-align connector with the backplane. The alignment features help prevent the stubbing of the contacts when the connector is positioned on the backplane. Known alignment features must be positioned in designated openings of the backplane as the connector is moved into electrical engagement with the backplane. However, when positioning high-speed / high density press fit connectors on a circuit board, there is very limited space on the circuit board to add alignment features due to the closely space routing of the traces on the printed circuit board and the high density of the plated thru-holes required. Openings needed for alignment features get in the way of the routing the high-speed traces.

It would therefore be beneficial to provide a press fit connector in which one or more of the retention pins also act as alignment members. In particular, it would be beneficial in a high-speed / high density press fit connector to have one or more of the retention pins, such as but not limited to, Eye of Needle (EON) pins, include an alignment feature thereon.

An embodiment is directed to an electrical connector assembly having a housing, signal contacts and ground contacts. The housing has a mounting side configured to face a circuit board. The signal contacts are provided in the housing and have signal contact circuit board mounting sections with signal contact compliant portions. The ground contacts are provided in the housing and have ground contact circuit board mounting sections with ground contact compliant portions. One or more of the signal contact compliant portions or the ground contact compliant portions have a larger width than the remainder of the signal contact compliant portions and the ground contact compliant portions. The one or more of the signal contact compliant portions or the ground contact compliant portions are configured to cooperate with one or more enlarged vias of the circuit board to align the connector assembly with the circuit board. A further embodiment is directed to an electrical connector assembly having a housing, signal contacts and ground contacts. The housing has a mounting side configured to face a circuit board. The signal contacts are provided in the housing and have signal contact circuit board mounting sections with signal contact lead in portions. The ground contacts are provided in the housing and have ground contact circuit board mounting sections with ground contact lead in portions. One or more of the signal contact lead in portions or the ground contact lead in portions extend from the mounting side of the housing a further distance than the remainder of the signal contact lead in portions and the ground contact lead in portions extend from the mounting side. The one or more of the signal contact lead in portions or the ground contact lead in portions are configured to engage a surface of the circuit board to provide a tactile indication to a user if the connector assembly is misaligned with respect to the circuit board.

The invention will now be described by way of example with reference to the accompanying drawings in which:
FIG. 1 is a perspective view of a circuit board with one illustrative embodiment of a press fit connector of the present invention mounted to the circuit board and a second press fit connector of the present invention shown prior to mating with the circuit board.
FIG. 2 is a perspective bottom view of one of the press fit connectors of FIG. 1.
FIG. 3 is an enlarged view of area 3 of FIG. 2.

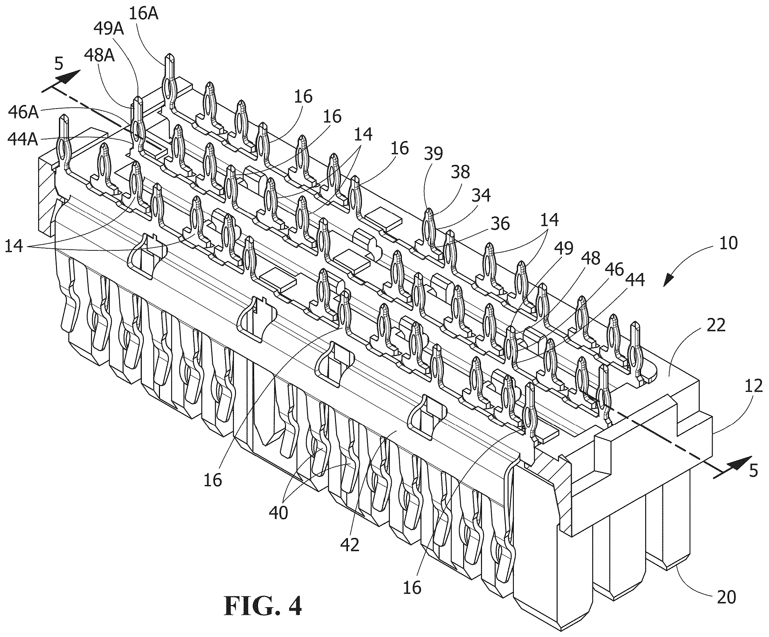

FIG. 4 is a cross-sectional view taken along line 4-4 of FIG. 2.
FIG. 5 is a cross-sectional view taken along line 5-5 of FIG. 4.
FIG. 6 is a top view of the circuit board of FIG. 1.
FIG. 7 is a side view of a first illustrative embodiment of a strip of contacts which have been removed from a housing of the press fit connector of FIG. 2.
FIG. 8 is a side view of a second illustrative embodiment of a strip of contacts.
FIG. 9 is a side view of a third illustrative embodiment of a strip of contacts.

The accompanying drawings, which are incorporated into and form a part of the specification, schematically illustrate one or more exemplary embodiments of the invention and, together with the general description given above and detailed description given below, serve to explain the principles of the invention.

The following provides a summary of certain illustrative embodiments of the present invention. This summary is not an extensive overview and is not intended to identify key or critical aspects or elements of the present invention or to delineate its scope.

An object is to prevent damaged retention pins due to misalignment as the press fit connector is inserted onto a circuit board.

An object is to have one or more of the retention pins of the press fit connector help align the press fit connector with the circuit board, thereby eliminating the need for a separate alignment mechanism.

An embodiment is directed to an electrical connector assembly having a housing, signal contacts and ground contacts. The housing has a mounting side configured to face a circuit board. The signal contacts are provided in the housing and have signal contact circuit board mounting sections with signal contact compliant portions. The ground contacts are provided in the housing and have ground contact circuit board mounting sections with ground contact compliant portions. One or more of the signal contact compliant portions or the ground contact compliant portions have a larger width than the remainder of the signal contact compliant portions and the ground contact compliant portions. The one or more of the signal contact compliant portions or the ground contact compliant portions are configured to cooperate with one or more enlarged vias of the circuit board to align the connector assembly with the circuit board.

An embodiment is directed to an electrical connector assembly having a housing, signal contacts and ground contacts. The housing has a mounting side configured to face a circuit board. The signal contacts are provided in the housing and have signal contact circuit board mounting sections with signal contact lead in portions. The ground contacts are provided in the housing and have ground contact circuit board mounting sections with ground contact lead in portions. One or more of the signal contact lead in portions or the ground contact lead in portions extend from the mounting side of the housing a further distance than the remainder of the signal contact lead in portions and the ground contact lead in portions extend from the mounting side. The one or more of the signal contact lead in portions or the ground contact lead in portions are configured to engage a surface of the circuit board to provide a tactile indication to a user if the connector assembly is misaligned with respect to the circuit board.

An embodiment is directed to an electrical connector assembly having a housing, signal contacts and ground contacts. The housing has a mounting side configured to face a circuit board. The signal contacts are provided in the housing and have signal contact circuit board mounting sections with signal contact compliant portions and signal contact lead in portions. The ground contacts are provided in the housing and have ground contact circuit board mounting sections with ground contact compliant portions and ground contact lead in portions. One or more of the signal contact compliant portions or the ground contact compliant portions have a larger width than the remainder of the signal contact compliant portions and the ground contact compliant portions. One or more of the signal contact lead in portions or the ground contact lead in portions extend from the mounting side of the housing a further distance than the remainder of the signal contact lead in portions and the ground contact lead in portions extend from the mounting side. The one or more of the signal contact compliant portions or the ground contact compliant portions are configured to cooperate with one or more enlarged vias of the circuit board to align the connector assembly with the circuit board. The one or more of the signal contact lead in portions or the ground contact lead in portions are configured to engage a surface of the circuit board to provide a tactile indication to a user if the connector assembly is misaligned with respect to the circuit board.

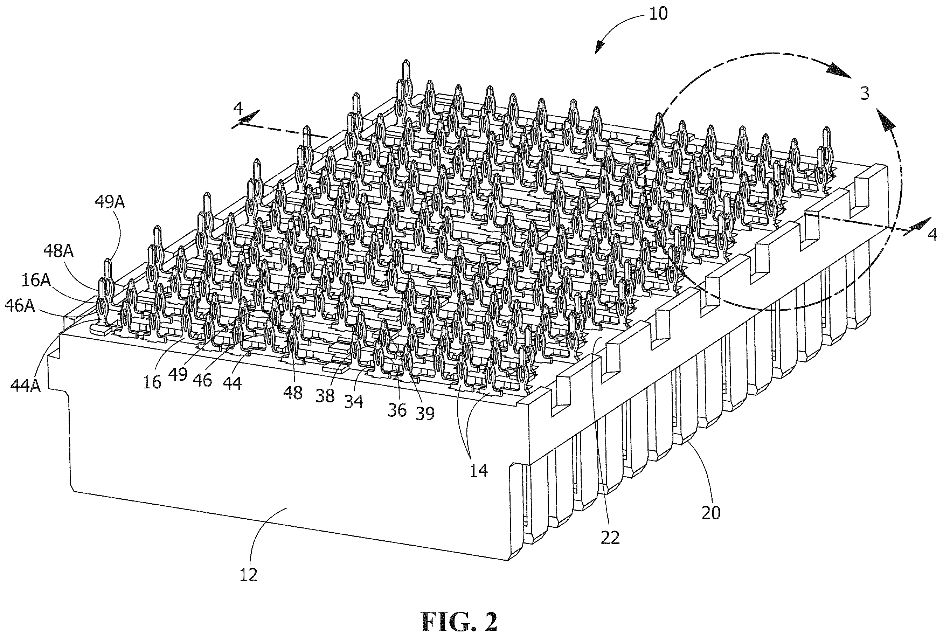

FIG. 2 is a bottom perspective view of an illustrative electrical connector assembly 10. In the illustrative embodiment, the electrical connector assembly 10 is an interference or press fit connector, but other configurations may be used. The electrical connector assembly 10 includes a connector housing 12 and an array of electrical contacts 14, 16 that are coupled to the connector housing 12. The electrical contacts 14, 16 include signal contacts 14 that are configured to transmit data signals therethrough and ground contacts 16 that are configured to shield the signal contacts 14 from electromagnetic interference (EMI) during operation. The electrical connector assembly 10 is configured to mate with another mating electrical connector (not shown).

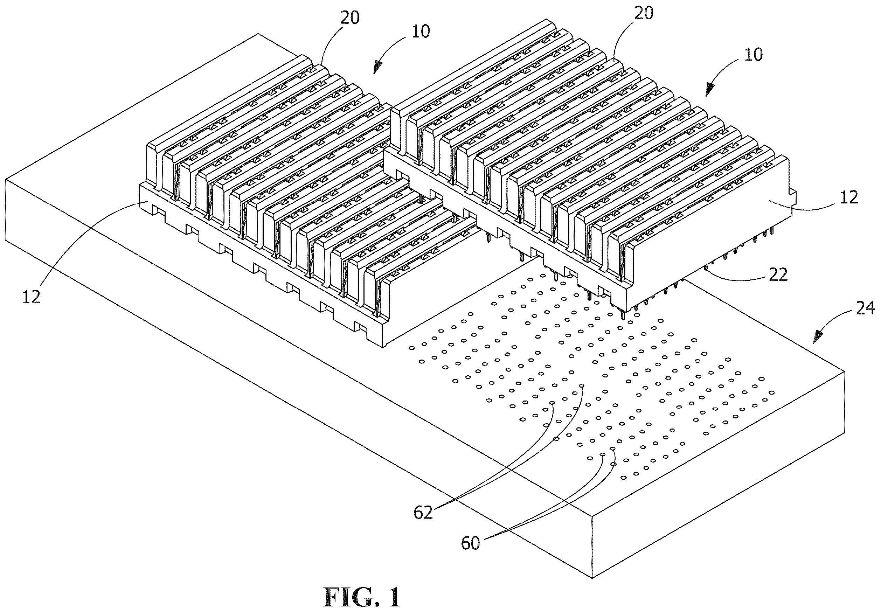

The connector housing 12 has a mating side 20 that is configured to mate with the mating connector and a mounting side 22 that is configured to face a circuit board 24 (shown in FIG. 1). The circuit board 24 may be, for example, a motherboard or a daughter card. In the illustrated embodiment, the mating and mounting sides 20, 22 face in opposite directions. In other embodiments, however, the electrical connector assembly 10 may have a right-angle configuration in which the mating and mounting sides 20, 22 face in directions that are perpendicular to each other.

In various illustrative embodiments, the signal contacts 14 are configured for differential signal communication. For example, the signal contacts 14 may be arranged in pairs in which each pair is surrounded by a corresponding ground contact 16. In the illustrated embodiment, the electrical connector assembly 10 is a vertical header connector. The mating connector may be a receptacle connector configured to mate with the header connector. The mating connector may be vertically oriented or, alternatively, may have a right-angle type configuration.

The electrical connector assemblies and circuit boards set forth herein may be used in various applications. By way of example only, embodiments may be used in telecom and computer applications, routers, servers, supercomputers, and uninterruptible power supply (UPS) systems. The circuit board assemblies may be backplane (or midplane) assemblies or daughter card assemblies that are configured to engage the backplane assemblies. For example, the signal lines of the electrical connectors may be capable of transmitting data signals at high speeds, such as 10 gigabits per second (Gb/s), 20 Gb/s, 30 Gb/s, or more. In more particular embodiments, the signal lines may be capable of transmitting data signals at 40 Gb/s, 50 Gb/s, or more. For some applications, the electrical connectors may include high-density, two-dimensional arrays of signal contacts. A high-density array may have, for example, at least 12 signal contacts per 100 mm². In more particular embodiments, the high-density array may have at least 20 signal contacts per 100 mm².

In the illustrative embodiment shown, each of the signal contacts 14 has a receiving section 30, a securing section 32 and circuit board mounting section 34. In the illustrative embodiment shown, the circuit board mounting sections 34 have compliant portions 36, such as, but not limited to, eye of the needle portions. Contact tails or lead in portions 38 extend from the compliant portions 36 to free ends or distal ends 39 of the signal contacts 14. The configuration of the signal contacts 14 is meant to be illustrative as other embodiments of the signal contacts may be used.

The receiving sections 30 of the signal contacts 14 are configured to engage corresponding mating electrical signal contacts (not shown) of a mating connector (not shown). The securing sections 32 cooperate with the connector housing 12 to retain the signal contacts 14 in the housing 12. The compliant portions 36 and the lead in portions 38 of the circuit board mounting sections 34 are configured to be inserted into vias 60 (shown in FIGS. 1 and 2), such as, but not limited to, plated thru-holes (PTH), of the circuit board 24. The lead in portions 38 projects from the compliant portions 36 and are configured to lead the circuit board mounting sections 34 into the via 60 of the circuit board 24. The compliant portions 36 mechanically and electrically engage conductive material of the vias 60.

In the illustrative embodiment shown, each of the ground contacts 16 has a receiving section 40, a securing section 42 and circuit board mounting section 44. In the illustrative embodiment shown, the circuit board mounting sections 44 have press-fit or compliant portions 46, such as, but not limited to, eye of the needle portions. Contact tails or lead in portions 48 extend from the compliant portions 46 to free ends or distal ends 49 of the ground contacts 16. The configuration of the ground contacts 16 is meant to be illustrative as other embodiments of the ground contacts may be used. In the illustrative embodiment shown, the ground contacts 16 are formed in grounding strips, with a common securing section 42 of each grounding strip being shared between multiple ground contacts 16 of the grounding strip.

The receiving sections 40 of the ground contacts 16 are configured to engage corresponding mating electrical ground contacts (not shown) of a mating connector (not shown). The securing sections 42 cooperate with the connector housing 12 to retain the ground contacts 16 in the housing 12. The compliant portions 46 and the lead in portions 48 of the circuit board mounting sections 44 are configured to be inserted into vias 62 (shown in FIGS. 1 and 2), such as, but not limited to, plated thru-holes (PTH), of the circuit board 24. The lead in portions 48 projects from the compliant portions 46 and are configured to lead the circuit board mounting sections 44 into the via 62 of the circuit board 24. The compliant portions 46 mechanically and electrically engage conductive material of the vias 62.

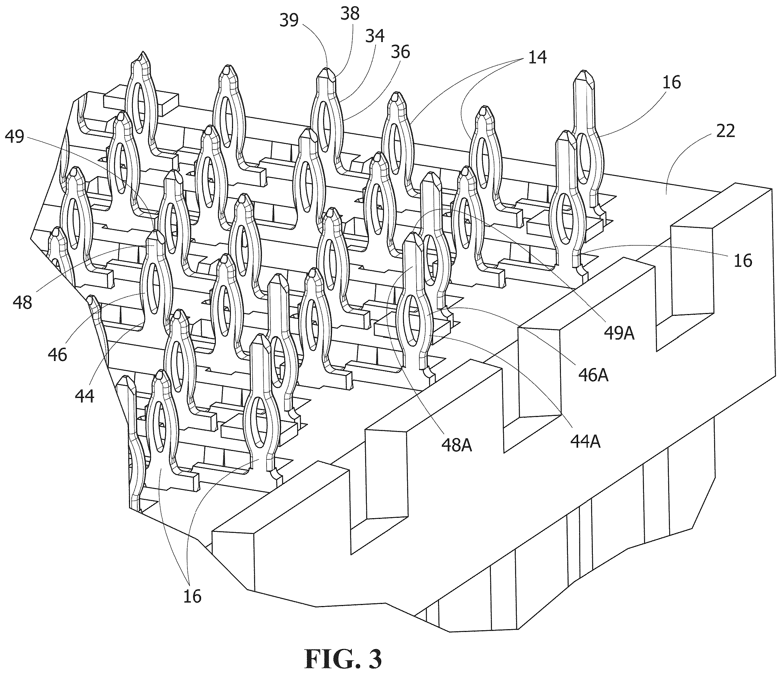

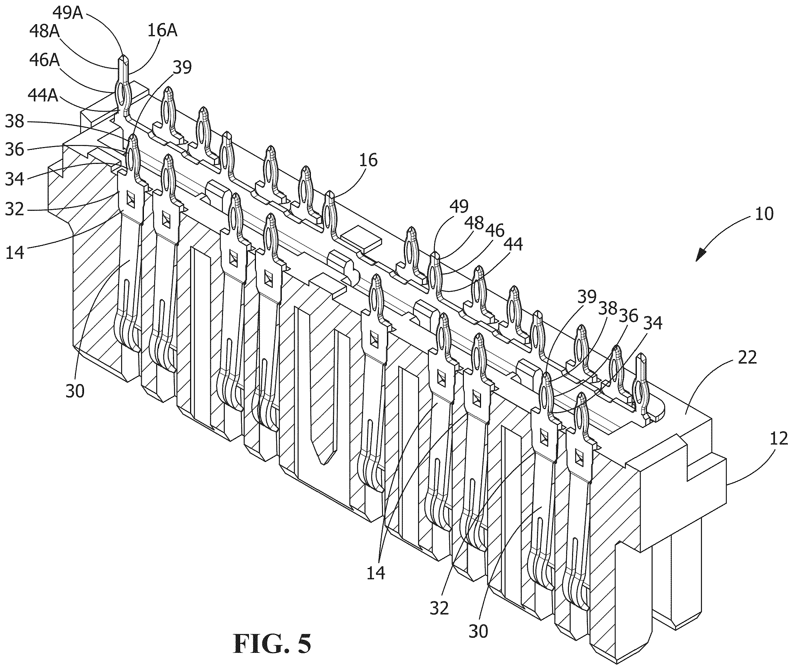

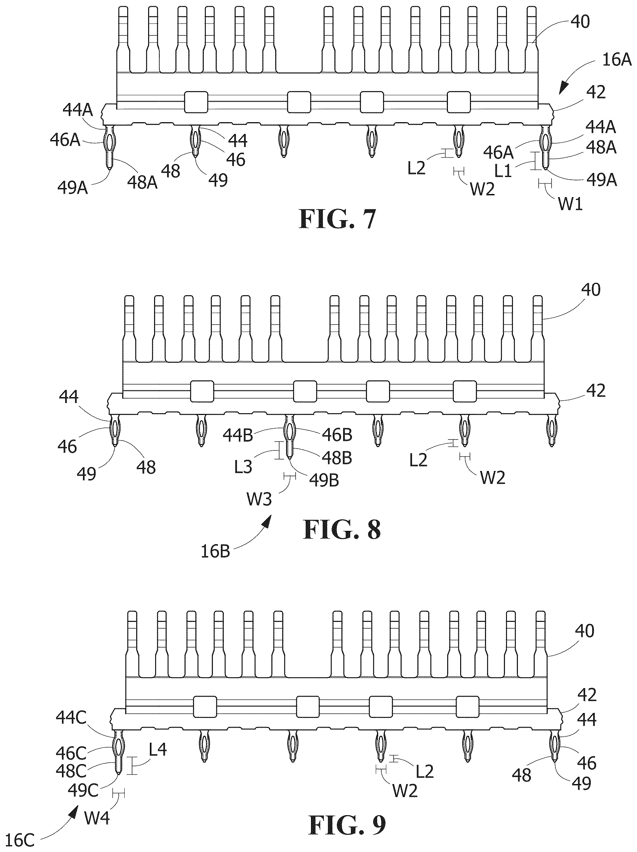

As shown in FIG. 3, 5 and 7 through 9, the size of the compliant portions 46 and lead in portions 48 may vary between individual ground contacts 16. For example, in FIG. 7, the ground contact 16A provided at either end of a grounding strip has a larger press-fit or compliant portion 46A. In this illustrative embodiment, the press-fit or compliant portions 46A have a larger width W1 than the width W2 of the compliant portions 46 of the remaining ground contacts 16. The lead in portions 48A have a larger length L1 than the length L2 of the lead in portions 48 of the remaining ground contacts 16 causing the distal ends 49A to be spaced further from the mating mounting side 22 of the housing 12 than the distal ends 49 of the remaining ground contacts 16 and the distal ends 39 of the signal contacts 14.

In other embodiments, the press-fit or compliant portions 46A have the same width as the compliant portions 46 of the remaining ground contacts 16. However, the lead in portions 48A have a larger length L1 than the length L2 of the lead in portions 48 of the remaining ground contacts 16 causing the distal ends 49A to be spaced further from the mating mounting side 22 of the housing 12 than the distal ends 49 of the remaining ground contacts 16 and the distal ends 39 of the signal contacts 14.

In the illustrative embodiment shown in FIG. 8, a ground contact 16B provided in the middle of a grounding strip has a larger press-fit or compliant portion 46B. In this illustrative embodiment, the press-fit or compliant portion 46B has a larger width W3 than the width W2 of the compliant portions 46 of the remaining ground contacts 16. The lead in portion 48B has a larger length L3 than the length L2 of the lead in portions 48 of the remaining ground contacts 16 causing the distal end 49B to be spaced further from the mating mounting side 22 of the housing 12 than the distal ends 49 of the remaining ground contacts 16 and the distal ends 39 of the signal contacts 14.

In the illustrative embodiment shown in FIG. 9, a ground contact 16C provided at one end of a grounding strip has a larger press-fit or compliant portion 46C. In this illustrative embodiment, the press-fit or compliant portion 46C has a larger width W4 than the width W2 of the compliant portions 46 of the remaining ground contacts 16. The lead in portion 48C has a larger length L4 than the length L2 of the lead in portions 48 of the remaining ground contacts 16 causing the distal end 49C to be spaced further from the mating mounting side 22 of the housing 12 than the distal ends 49 of the remaining ground contacts 16 and the distal ends 39 of the signal contacts 14.

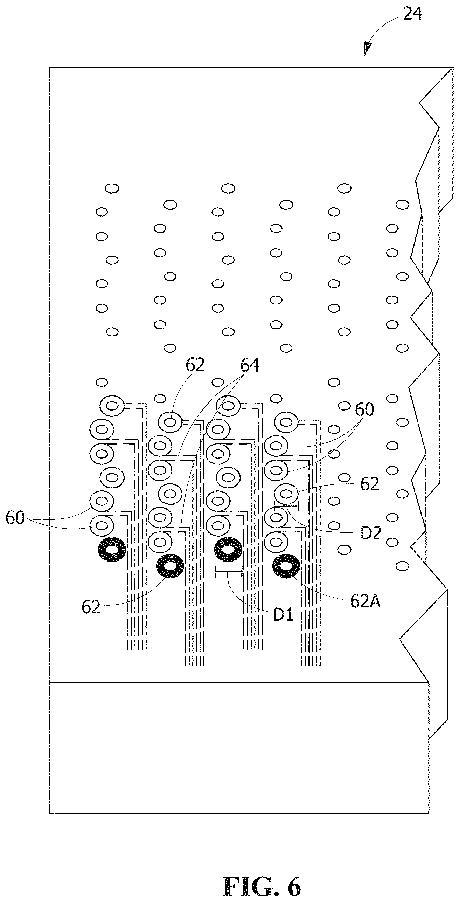

As shown in FIG. 6, the circuit board 24 has vias or plated thru-holes 60 for receiving the circuit board mounting sections 34 of the signal contacts 14 and vias or plated thru-holes 62 for receiving the circuit board mounting sections 44 of the ground contacts 16. The size of the vias 62 may vary between individual vias 62. In this illustrative embodiment, the vias 62A have a larger diameter D1 than the diameter D2 of the remaining vias 62. The vias 62A are configured to receive the compliant portions 46A, 46B or 46C of the ground contacts 16A, 16B or 16C therein.

As the electrical connector assembly 10 is mounted to the circuit board 24, the circuit board mounting sections 34 of the signal contacts 14 may not be properly aligned with the vias 60 of the circuit board 24 and the circuit board mounting sections 44 of the ground contacts 16 may not be properly aligned with the vias 62 of the circuit board 24. As the distal ends 49A, 49B or 49C are spaced further from the mating mounting side 22 of the housing 12 than the distal ends 49 of the remaining ground contacts 16 and the distal ends 39 of the signal contacts 14, the distal ends 49A, 49B or 49C engage the surface of the circuit board 24 prior to the distal ends 49 of the remaining ground contacts 16 and the distal ends 39 of the signal contacts 14. As this occurs, the resistance and/or friction between the distal ends 49A, 49B or 49C of the ground contacts 16A, 16B or 16C and the surface of the circuit board 24 may provide a tactile indication to a user that the electrical connector 10 is misaligned with respect to the circuit board 24. The user may then move the electrical connector 10 in a lateral direction along the surface of the circuit board 24 until the distal ends 49A, 49B or 49C are received within the corresponding vias 62A, 62B or 62C. As this occurs, the distal ends 49 of the other ground contacts 16 and the distal ends 39 of the signal contacts 14 are spaced from the surface of the circuit board 24 and consequently protected from damage. In such embodiments, the distal ends 49 of the other ground contacts 16 and the distal ends 39 of the signal contacts 14 engage the vias 62, 60 only after the ground contacts 16A, 16B or 16C are sufficiently aligned with and enter the vias 62A, 62B or 62C. As the distal ends 49A, 49B or 49C of the ground contacts 16A, 16B or 16C advance into the corresponding vias 62A, 62B or 62C, the distal ends 49 of the other ground contacts 16 and the distal ends 39 of the signal contacts 14 should be substantially aligned with corresponding vias 62, 60, thereby preventing damage of the distal ends 49 of the other ground contacts 16 and the distal ends 39 of the signal contacts 14 due to misalignment with the vias 62, 60.

As the compliant portions 46A, 46B or 46C of the ground contacts 16A, 16B or 16C can only be inserted into the enlarged vias 62A, the compliant portions 46A, 46B or 46C of the ground contacts 16A, 16B or 16C act as a keying mechanism to ensure that the connector assembly 10 is properly positioned on the circuit board 24.

While the illustrative embodiments shown and described herein have the enlarged compliant portions and enlarged lead in portions provided on select ground contacts, the enlarged compliant portions and enlarged lead in portions may be provided on select signal contacts, or both select ground contacts and select signal contacts. The use of the enlarged compliant portions on select contacts facilitates the alignment of the connector assembly 10 on the circuit board 24, particularly in applications in which require a high-density array. Due to the routing of the traces 64 on the circuit board 24, there is very limited space to add alignment pins or other features to the connector assembly 10, as the corresponding holes in the circuit board 24 needed to accommodate those features would get in the way of the routing the high-speed traces 64. Therefore, the use of larger compliant sections and longer lead in portions on select contacts provides proper alignment without the need for additional vias in the circuit board, thereby preventing damage to all of the contacts due to misalignment.

## Claims

1. An electrical connector assembly (10) comprising:
a housing (12) having a mounting side (22) configured to face a circuit board (24);
signal contacts (14) provided in the housing (12), the signal contacts (14) having signal contact circuit board mounting sections (34) with signal contact compliant portions (36);
ground contacts (16) provided in the housing (12), the ground contacts (16) having ground contact circuit board mounting sections (44) with ground contact compliant portions (46);
wherein one or more of the signal contact compliant portions (36) or the ground contact compliant portions (46) have a larger width than the remainder of the signal contact compliant portions (36) and the ground contact compliant portions (46);
wherein the one or more of the signal contact compliant portions (36) or the ground contact compliant portions (46) are configured to cooperate with one or more enlarged vias (60, 62) of the circuit board (24) to align the connector assembly (10) with the circuit board (24).

2. An electrical connector assembly (10) according to Claim 1, wherein the signal contacts (14) have signal contact lead in portions (38) which extend from the signal contact compliant portions (36) in a direction away from the mounting side (22) of the housing (12).

3. An electrical connector assembly (10) according to Claim 2, wherein the ground contacts (16) have ground contact lead in portions (48) which extend from the ground contact compliant portions (46) in a direction away from the mounting side (22) of the housing (12).

4. An electrical connector assembly (10) according to Claim 3, wherein one or more of the signal contact lead in portions (38) or the ground contact lead in portions (48) extend from the mounting side (22) of the housing (12) a further distance than the remainder of the signal contact lead in portions (38) and the ground contact lead in portions (48) extend from the mounting side (22).

5. An electrical connector assembly (10) according to any preceding claim, wherein the signal contacts (14) have receiving sections (30) configured to engage a mating contact and securing sections (32) for retaining the signal contacts (14) in the housing (12).

6. An electrical connector assembly (10) according to any preceding claim, wherein the ground contacts (16) have receiving sections (40) configured to engage a mating contact and securing sections (42) for retaining the ground contacts (16) in the housing (12).

7. An electrical connector assembly (10) according to any preceding claim, wherein the signal contact compliant portions (36) and the ground contact compliant portions (46) have eye of the needle configurations.

8. An electrical connector assembly (10) comprising:
a housing (12) having a mounting side (22) configured to face a circuit board (24);
signal contacts (14) provided in the housing (12), the signal contacts (14) having signal contact circuit board mounting sections (34) with signal contact lead in portions (38);
ground contacts (16) provided in the housing (12), the ground contacts (16) having ground contact circuit board mounting sections (44) with ground contact lead in portions (48);
wherein one or more of the signal contact lead in portions (38) or the ground contact lead in portions (48) extend from the mounting side (22) of the housing (12) a further distance than the remainder of the signal contact lead in portions (38) and the ground contact lead in portions (48) extend from the mounting side (22);
wherein the one or more of the signal contact lead in portions (38) or the ground contact lead in portions (48) are configured to engage a surface of the circuit board (24) to provide a tactile indication to a user if the connector assembly (10) is misaligned with respect to the circuit board (24).

9. An electrical connector assembly (10) according to Claim 8, wherein the signal contacts (14) have signal contact compliant portions (36) which are provided between the mounting side (22) of the housing (12) and the signal contact lead in portions (38).

10. An electrical connector assembly (10) according to Claim 9, wherein the ground contacts (16) have ground contact compliant portions (46) which are provided between the mounting side (22) of the housing (12) and the ground contact lead in portions (48).

11. An electrical connector assembly (10) according to Claim 10, wherein the signal contact compliant portions (36) and the ground contact compliant portions (46) have eye of the needle configurations.

12. An electrical connector assembly (10) according to Claim 10 or Claim 11, wherein one or more of the signal contact compliant portions (36) or the ground contact compliant portions (46) have a larger width than the remainder of the signal contact compliant portions (36) and the ground contact compliant portions (46), wherein the one or more of the signal contact compliant portions (36) or the ground contact compliant portions (46) are configured to cooperate with one or more enlarged vias (60, 62) of the circuit board (24) to align the connector assembly (10) with the circuit board (24).

13. An electrical connector assembly (10) according to any of Claims 8 to 12, wherein the signal contacts (14) have receiving sections (30) configured to engage a mating contact and securing sections (32) for retaining the signal contacts (14) in the housing (12).

14. An electrical connector assembly (10) according to any of Claims 8 to 13, wherein the ground contacts (16) have receiving sections (40) configured to engage a mating contact and securing sections (42) for retaining the ground contacts (16) in the housing (12).
